# FASCICULE DE BREVET EUROPEEN

(11) **EP 3 360 391 B1**
(45) Date de publication et mention de la délivrance du brevet: **07.06.2023**
(21) Numéro de dépôt: 16790659.3
(22) Date de dépôt: 04.10.2016
(51) Int. Cl.: H05B 6/70, H01R 9/05, H05B 6/80, H05H 1/46

(54) **DISPOSITIF ÉLÉMENTAIRE D'APPLICATION D'UNE ÉNERGIE MICRO-ONDE AVEC APPLICATEUR COAXIAL**
ELEMENTARE VORRICHTUNG ZUM ANLEGEN VON MIKROWELLENENERGIE MIT EINEM KOAXIALEN APPLIKATOR
ELEMENTARY DEVICE FOR APPLYING A MICROWAVE ENERGY WITH COAXIAL APPLICATOR

(30) Priorité: 05.10.2015 FR 1559458
(43) Date de publication de la demande: 15.08.2018
(73) Titulaire: Sairem Societe Pour L'application Industrielle De La Recherche En Electronique Et Micro Ondes, 01700 Neyron (FR)
(72) Inventeur: LATRASSE, Louis, 69380 Dommartin (FR); RADOIU, Marilena, 69140 Rillieux-la-pape (FR)
(74) Mandataire: Germain Maureau
(86) Numéro de dépôt international: PCT/FR2016/052545
(87) Numéro de publication internationale: WO 2017/060611

(56) Documents cités:
- WO-A1-2012/146870
- WO-A1-2014/184357
- FR-A1- 2 955 451
- US-A- 4 261 630
- US-A1- 2010 171 425
- US-A1- 2013 157 505
- US-B1- 7 946 886

## Description

La présente invention se rapporte à un dispositif élémentaire d'application d'une énergie micro-onde, et à une installation de traitement micro-onde d'une charge utilisant au moins un tel dispositif élémentaire.

Elle se rapporte plus particulièrement à dispositif élémentaire comprenant un applicateur coaxial de puissance micro-onde.

La présente invention trouve une application dans le domaine du traitement micro-onde d'une charge, cette charge pouvant être du type solide (par exemple du type granuleux ou pulvérulent), gazeux, plasma, liquide (avec un solvant et/ou des solutés absorbant le rayonnement électromagnétique). Il est à noter que l'énergie micro-onde concerne les ondes dont la fréquence est comprise entre environ 300 MHz et environ 30 GHz, préférentiellement entre 400 MHz et 10 GHz, et préférentiellement entre 915 MHz et 5,8 GHz.

L'invention s'applique dans le domaine du traitement thermique d'un milieu réactif, où par « traitement thermique » on entend divers traitements effectués par chauffage tels qu'évaporation, séchage, grillage, extraction de produits naturels en suspension dans un solvant, réaction ou synthèse chimique avec chauffage par pertes diélectriques (en vue d'analyse ou de production de composés chimiques), déshydratation, cuisson, décoloration, désolidarisation, polymérisation, réticulation, traitements par fluides supercritiques, élimination de composés volatils etc. ainsi que divers traitements opérés simultanément au chauffage, tels que mélange ou broyage.

L'invention s'applique également dans le domaine de la production de plasma à l'intérieur d'une enceinte de confinement, pour diverses applications telles que par exemple le nettoyage de surface, la stérilisation, le dépôt, notamment le dépôt chimique en phase vapeur assistée par plasma, la gravure, l'implantation ionique, la fonctionnalisation de surface et autres traitements de surface tels que la pulvérisation ionique (ou pulvérisation cathodique).

Pour la transmission de l'énergie micro-onde entre un générateur et l'intérieur de l'enceinte, il est nécessaire d'employer au moins un dispositif élémentaire d'application de l'énergie micro-onde, et généralement une pluralité de tels dispositifs élémentaires en association, qui sont souvent appelés sources élémentaires.

Il est ainsi connu des documents WO 2014/184357 et WO 2012/146870 d'employer un dispositif élémentaire d'application d'une énergie micro-onde, qui comprend un applicateur coaxial de puissance micro-onde.

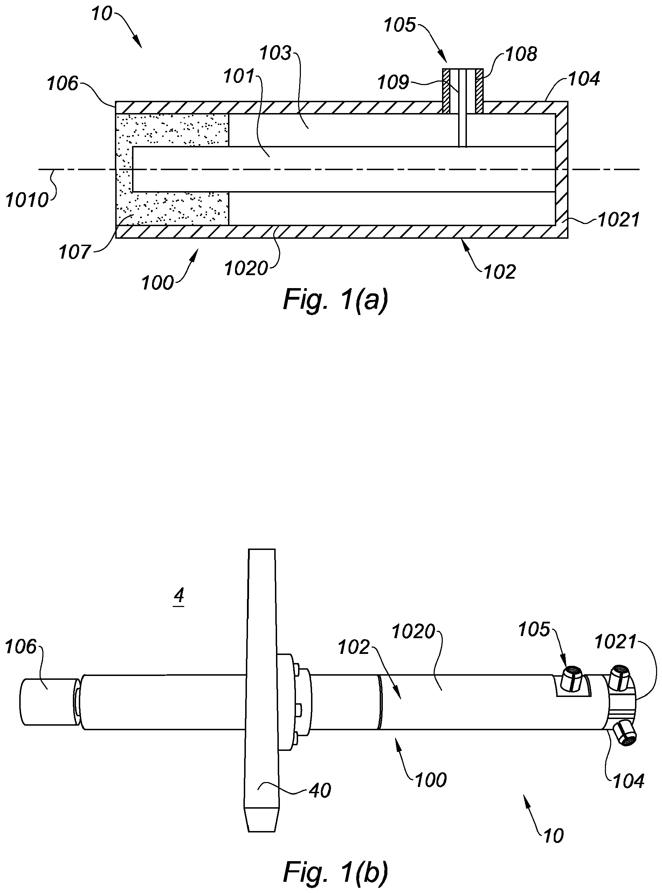

En référence aux figures 1(a) et 1(b), un dispositif élémentaire 10 classique comporte un applicateur coaxial 100 de puissance micro-onde qui permet de transmettre l'énergie micro-onde provenant d'un générateur d'énergie micro-onde (non illustré) vers l'enceinte 4 délimitée par une cloison 40 (illustrés sur la figure 1(b)).

Un tel applicateur coaxial 100 comporte une âme centrale 101 conductrice s'étendant selon un axe principal 1010, un blindage 102 externe conducteur entourant l'âme centrale 101, et un milieu de propagation 103 d'une énergie micro-onde situé entre l'âme centrale 101 et le blindage 102.

Cet applicateur coaxial 100 présente une extrémité distale 104 munie d'un connecteur à structure coaxiale 105 prévu pour le couplage avec le générateur et une extrémité proximale 106 opposée prévue pour déboucher à l'intérieur de l'enceinte 4, cette extrémité proximale 106 étant munie d'un corps isolant 107 en matériau diélectrique transparent à l'énergie micro-onde.

En outre, le blindage 102 présente une paroi périphérique 1020 entourant l'âme centrale 101 et une paroi de fond 1021 prévue sur l'extrémité distale 104 et s'étendant transversalement par rapport à l'axe principal 1010.

De manière connue, le connecteur à structure coaxiale 105 est pourvu d'un conducteur externe 108 connecté au blindage 102 et entourant un conducteur interne 109 connecté à l'âme centrale 101. Ce connecteur à structure coaxiale 105 est classiquement disposé sur la paroi périphérique 1020 du blindage 102, à une distance prédéfinie vis-à-vis de la paroi de fond 1021 de l'ordre du quart d'onde (soit un quart de la longueur d'onde de l'énergie micro-onde) pour favoriser la transmission de l'énergie vers l'applicateur coaxial 100 sans générer de puissance réfléchie. Le conducteur interne 109 traverse la paroi périphérique 1020 du blindage 102 et s'étend selon une direction orthogonale à l'axe principal 1010 pour venir au contact avec l'âme centrale 101 à une distance D vis-à-vis de la paroi de fond 1021 de l'ordre du quart d'onde.

Ce dispositif élémentaire 10 classique présente comme inconvénient majeur son encombrement latéral ou périphérique induit par la présence du connecteur à structure coaxiale 105 sur la paroi périphérique 1020 du blindage 102.

Dans certaines applications, il est nécessaire de prévoir plusieurs dispositifs élémentaires montés côte à côte sur la cloison de l'enceinte et connectés à des câbles ou guides coaxiaux. Or, les connecteurs à structure coaxiale 105 de ces dispositifs élémentaires 10 empêchent un trop grand rapprochement entre les dispositifs élémentaires 10, en particulier lorsque la surface de réception sur la cloison est restreinte.

Par ailleurs, ce positionnement périphérique du connecteur à structure coaxiale 105 gêne le placement du câble ou guide coaxial qui doit être courbé pour pouvoir être connecté au connecteur à structure coaxiale 105. Une telle courbure du câble ou guide coaxial n'est cependant pas envisageable lors d'une trop grande proximité entre les dispositifs élémentaires 10, de sorte qu'il devient alors nécessaire de connecter les câbles ou guides coaxiaux sur les connecteurs à structure coaxiale 105 via des coudes coaxiaux à angle droit, complexifiant ainsi le montage.

En résumé, les conformations de ces dispositifs élémentaires 10 vont gêner voire empêcher une implantation compacte des dispositifs élémentaires 10 et des câbles ou guides coaxiaux associés.

La présente invention a pour but de résoudre ces inconvénients et, à cet effet, elle propose un dispositif élémentaire d'application d'une énergie micro-onde, du type comprenant un applicateur coaxial de puissance micro-onde présentant, d'une part, une extrémité distale munie d'un connecteur à structure coaxiale prévu pour le couplage avec un câble ou guide coaxial raccordé à un générateur d'énergie micro-onde et, d'autre part, une extrémité proximale opposée prévue pour déboucher à l'intérieur d'une enceinte, ledit applicateur coaxial comprenant :
- une âme centrale conductrice s'étendant selon un axe principal,
- un blindage externe conducteur présentant une paroi périphérique entourant cette âme centrale et une paroi de fond prévue sur l'extrémité distale et s'étendant transversalement par rapport à l'axe principale,
- un milieu de propagation de l'énergie micro-onde situé entre l'âme centrale et le blindage, et
- un corps isolant en matériau diélectrique, transparent à l'énergie micro-onde et disposé sur l'extrémité proximale ;

où le connecteur à structure coaxiale est pourvu d'un conducteur externe connecté au blindage et entourant un conducteur interne connecté à l'âme centrale ;
où le dispositif élémentaire est remarquable en ce que le connecteur à structure coaxiale est disposé sur la paroi de fond du blindage en ayant son conducteur externe fixé sur cette paroi de fond et son conducteur interne raccordé à un élément de connexion longiligne qui traverse la paroi de fond et qui s'étend, à partir de cette paroi de fond, substantiellement parallèlement à l'axe principal avec un écartement prédéfini vis-à-vis de l'âme centrale jusqu'à une extrémité libre connectée sur cette âme centrale à une distance prédéfinie de la paroi de fond.

Ainsi, le connecteur à structure coaxiale est placé sur la paroi de fond du blindage et son axe coaxial est substantiellement parallèle à l'axe principal de l'applicateur coaxial. De cette manière, le connecteur à structure coaxiale ne procure aucun encombrement latéral, et le câble ou guide coaxial sera branché directement sur le connecteur à structure coaxiale, sans nécessiter d'employer un coude coaxial à angle droit ou de prévoir un coude sur le câble ou guide coaxial, permettant ainsi une implantation compacte des dispositifs élémentaires et des câbles ou guides coaxiaux associés sur la cloison d'une enceinte.

Bien entendu, il est envisageable que le connecteur à structure coaxiale soit connecté directement au générateur par le guide ou câble coaxial, tout comme il est envisageable qu'un ou plusieurs dispositifs, tels qu'un diviseur de puissance ou un adaptateur, soient placés entre le connecteur à structure coaxiale et le générateur.

Selon une caractéristique, l'âme centrale supporte un organe de connexion qui est au contact avec l'extrémité libre de l'élément de connexion à la distance prédéfinie de ladite paroi de fond.

Selon une autre caractéristique, l'organe de connexion est fixé sur l'extrémité libre de l'élément de connexion, notamment par vissage au moyen d'une vis, par soudage ou par sertissage.

Dans une réalisation particulière, l'organe de connexion est soudé sur l'âme centrale.

Dans un mode de réalisation particulier, l'élément de connexion présente successivement :
- une portion initiale cylindrique de diamètre réduit connectée au conducteur interne du connecteur à structure coaxiale ;
- une portion intermédiaire tronconique ;
- une portion finale cylindrique de diamètre augmenté qui se termine par l'extrémité libre connectée sur ladite âme centrale.

Dans une variante adaptée pour une fréquence de l'ordre de 915 MHz, la portion finale peut être de forme incurvée, et la portion intermédiaire de forme non spécifiquement cylindrique.

Selon une possibilité de l'invention, le dispositif élémentaire constitue un dispositif élémentaire de production d'un plasma à l'intérieur de l'enceinte.

La présente invention concerne également une installation de traitement micro-onde d'une charge, comprenant :
- une enceinte dans le volume de laquelle la charge est confinée ;
- au moins un générateur d'énergie micro-onde ;
- au moins un dispositif élémentaire conforme à l'une quelconque des revendications précédentes, dont le connecteur à structure coaxiale est connecté à un câble ou guide coaxial raccordé audit générateur d'énergie micro-onde et dont l'extrémité proximale de l'applicateur coaxial débouche à l'intérieur de ladite enceinte.

D'autres caractéristiques et avantages de la présente invention apparaîtront à la lecture de la description détaillée ci-après, d'exemples de mise en oeuvre non limitatifs, faite en référence aux figures annexées dans lesquelles :
- la figure 1(a), déjà commentée, est une vue schématique en coupe axiale d'un dispositif élémentaire classique ;
- la figure 1(b), déjà commentée, est une vue schématique en perspective d'un autre dispositif élémentaire classique ;
- la figure 2 est une vue schématique en coupe axiale d'un premier dispositif élémentaire conforme à l'invention ;
- la figure 3 est une vue schématique en coupe axiale d'un deuxième dispositif élémentaire conforme à l'invention ;
- la figure 4 est une vue schématique en perspective du premier ou deuxième dispositif élémentaire ;
- la figure 5 est une vue schématique de l'intérieur d'une enceinte à plasma dans laquelle sont placés plusieurs premiers ou deuxièmes dispositifs élémentaires de la figure 4 ;
- la figure 6 est une vue schématique en coupe axiale et non détaillée d'un troisième dispositif élémentaire conforme à l'invention ;
- la figure 7 est une vue schématique en perspective du troisième dispositif élémentaire de la figure 6 ;
- la figure 8 est une vue schématique de l'intérieur d'une enceinte à plasma dans laquelle sont placés plusieurs troisièmes dispositifs élémentaires de la figure 7 ; et
- la figure 9 est une vue schématique d'une enceinte sur la cloison de laquelle sont montés plusieurs dispositifs élémentaires conformes à l'invention, avec visibles des câbles coaxiaux connectés aux différents dispositifs élémentaires.

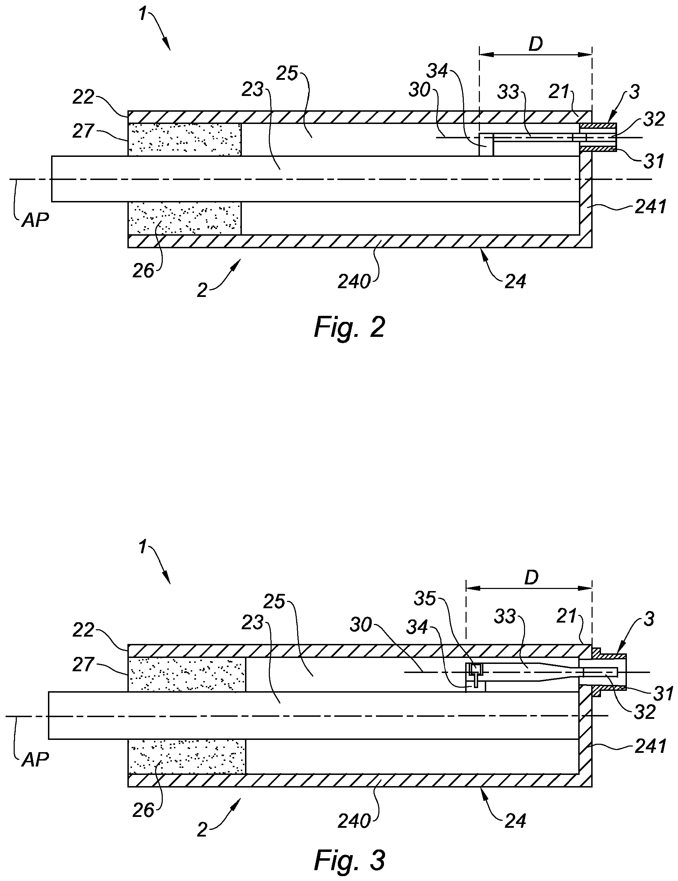

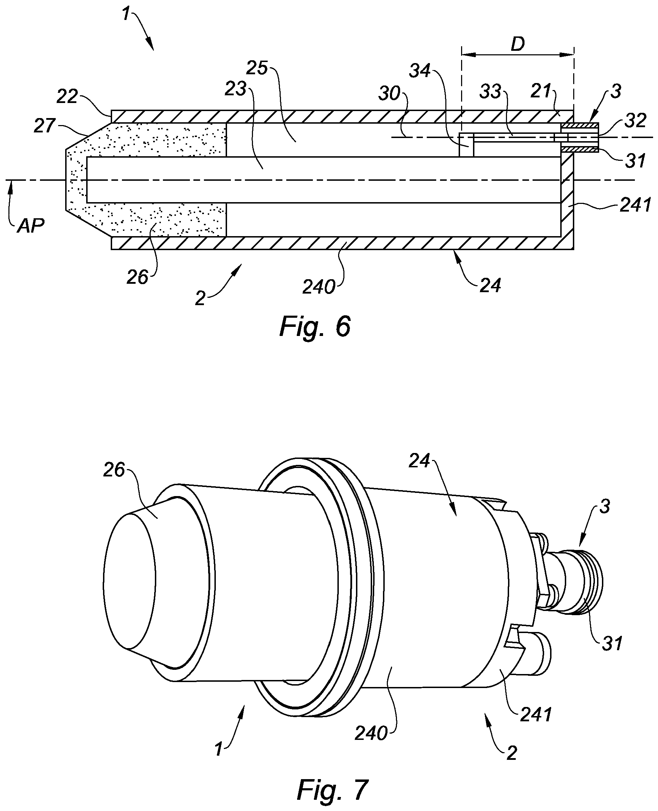

Les figures 2 à 8 illustrent trois modes de réalisation d'un dispositif élémentaire 1 de production d'un plasma, avec un premier et un deuxième modes de réalisation illustrés sur les figures 2 à 5 et un troisième mode de réalisation illustré sur les figures 6 à 8, et, sauf indication explicite ou implicite contraire, des organes, pièces, dispositifs ou éléments structurellement ou fonctionnellement identiques ou similaires seront désignés par des repères identiques sur ces figures.

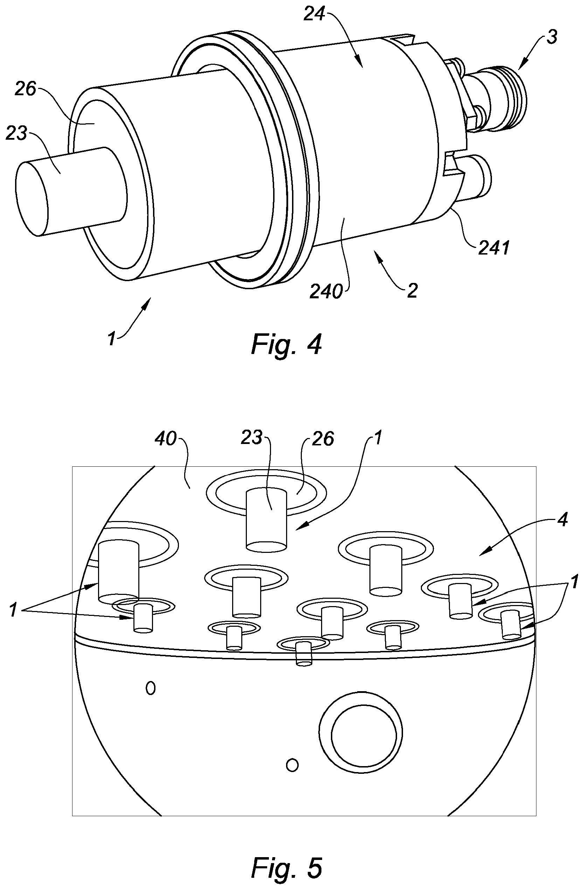

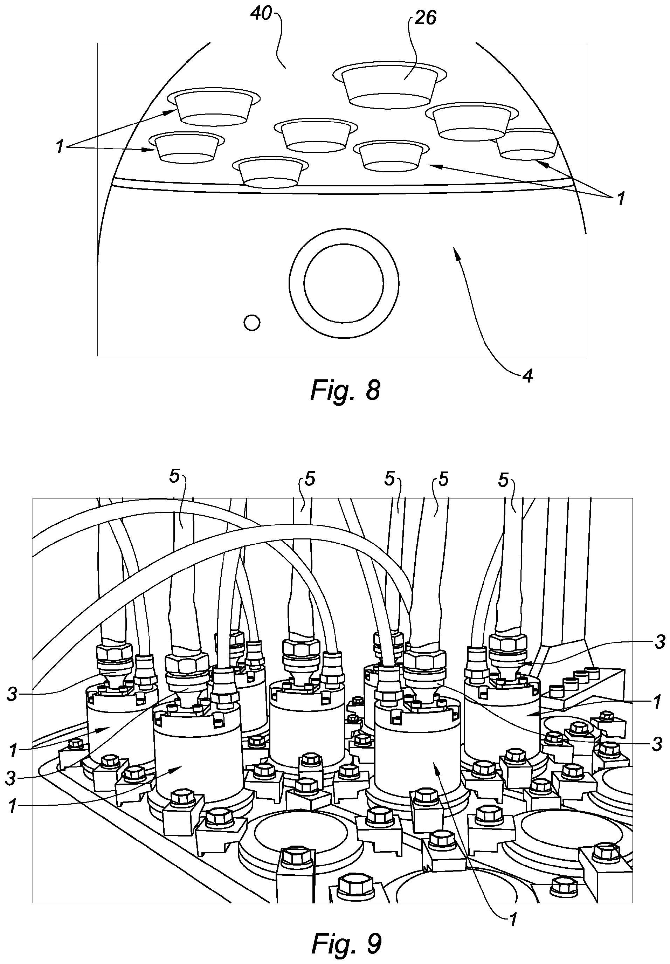

Le dispositif élémentaire 1 comprend un applicateur coaxial 2 de puissance micro-onde, prévu pour assurer la transmission d'une énergie micro-onde entre un générateur d'énergie micro-onde (non illustré), notamment du type générateur à état solide, et l'intérieur d'une enceinte 4 contenant une charge à traiter, notamment du type enceinte à plasma (visible sur les figures 5 et 8).

Cet applicateur coaxial 2 est réalisé sous une forme filaire, c'est-à-dire allongée selon un axe principal AP, et il présente :
- une extrémité distale 21 munie d'un connecteur à structure coaxiale 3 prévu pour le couplage avec un câble ou guide coaxial 5 (visible sur la figure 9) raccordé à un générateur d'énergie micro-onde ; et
- une extrémité proximale 22 opposée prévue pour déboucher à l'intérieur de l'enceinte 4.

L'applicateur coaxial 2 comprend :
- une âme centrale 23 conductrice s'étendant selon l'axe principal AP ;
- un blindage 24 externe conducteur entourant l'âme centrale 23, ce blindage externe 24 se présentant sous la forme d'un manchon creux comprenant une paroi périphérique 240 présentant une face interne cylindrique centrée sur l'axe principal AP, et une paroi de fond 241 fermant l'extrémité distale 21 de l'applicateur coaxial 2 ;
- un milieu de propagation 25 de l'énergie micro-onde situé entre l'âme centrale 23 et le blindage 24, ce milieu de propagation 25 étant par exemple composé en tout ou partie d'air ; et
- un corps isolant 26 en matériau diélectrique transparent à l'énergie micro-onde, ce corps isolant 26 étant disposé sur l'extrémité proximale 22 de l'applicateur coaxial 2.

La paroi de fond 241 peut être rapportée fixement sur la paroi périphérique 240 ou bien venir de matière avec celle-ci.

Le corps isolant 26 bouche complètement l'extrémité proximale 22 de l'applicateur coaxial 2, séparant ainsi l'intérieur de l'enceinte 4, qui est souvent maintenue à basse pression, du milieu de propagation 25, qui est à la pression atmosphérique ambiante. Le corps isolant 26 présente une surface externe 27 prévue pour être au contact avec l'intérieur de l'enceinte 4, et notamment avec un gaz à exciter localisé à l'intérieur de l'enceinte 4 dans le cas d'une application plasma.

Dans les premier et deuxième modes de réalisation des figures 2 à 5, la surface externe 27 du corps isolant 26 vient en arasement avec l'extrémité proximale du blindage 24, et ne dépasse donc pas du blindage 24. En outre, l'âme centrale 23 traverse complètement le corps isolant 26 et dépasse extérieurement de celui-ci.

Dans le troisième mode de réalisation des figures 6 à 8, la surface externe 27 du corps isolant 26 dépasse extérieurement de l'extrémité proximale du blindage 24. En outre, l'âme centrale 23 présente une extrémité proximale noyée à l'intérieur du corps isolant 26, sans traverser complètement ce corps isolant 26.

Conformément à l'invention, le connecteur à structure coaxiale 3 est disposé sur la paroi de fond 241 du blindage 24, et présente un conducteur externe 31 connecté à la paroi de fond 241 du blindage 24 et entourant un conducteur interne 32 connecté à l'âme centrale 23 de l'applicateur coaxial 2.

Le connecteur à structure coaxiale 3 est plus précisément fixé au moyen de vis sur la paroi de fond 241 du blindage 24, côté extérieur. Ce connecteur à structure coaxiale 3 présente un axe de coaxialité 30 parallèle à l'axe principal AP de l'applicateur coaxial 2.

Le conducteur interne 32 est connecté à l'âme centrale 23 au moyen d'un élément de connexion 33 longiligne et conducteur qui présente une extrémité raccordée au conducteur interne 32 et une extrémité opposée, dite extrémité libre, raccordée à l'âme centrale 23.

Cet élément de connexion 33 s'étend dans le prolongement du connecteur à structure coaxiale 3 et s'étend donc selon l'axe de coaxialité 30, parallèlement à l'axe principal AP de l'applicateur coaxial 2.

Le connecteur à structure coaxiale 3 est déporté radialement par rapport à l'axe principal AP (autrement dit l'axe de coaxialité 30 et l'axe principal AP ne sont pas colinéaires) de sorte que l'élément de connexion 33 s'étend substantiellement parallèlement à l'axe principal AP avec un écartement prédéfini vis-à-vis de l'âme centrale 23 jusqu'à son extrémité libre. L'élément de connexion 33 traverse la paroi de fond 241 du blindage 24.

De manière plus précise, l'âme centrale 23 supporte un organe de connexion 34 qui est soudé sur l'âme centrale à une distance D prédéfinie de la paroi de fond 241 du blindage 24.

Cet organe de connexion 34 est au contact de l'extrémité libre de l'élément de connexion 33, et est plus précisément fixé sur l'extrémité libre de l'élément de connexion 33.

Dans les premier et troisième modes de réalisation des figures 2 et 6, l'organe de connexion 34 est fixé sur l'extrémité libre de l'élément de connexion 33 par soudage.

Dans le deuxième mode de réalisation de la figure 3, l'organe de connexion 34 est fixé sur l'extrémité libre de l'élément de connexion 33 au moyen d'une vis 35.

Dans une variante non illustrée, l'organe de connexion 34 est fixé sur l'extrémité libre de l'élément de connexion 33 par sertissage.

Dans les premier et troisième modes de réalisation des figures 2 et 6, l'élément de connexion 33 se présente sous la forme d'une tige cylindrique de diamètre constant.

Dans le deuxième mode de réalisation de la figure 3, l'élément de connexion 33 présente successivement :
- une portion initiale cylindrique de diamètre réduit connectée au conducteur interne 32 du connecteur à structure coaxiale 3 ;
- une portion intermédiaire tronconique ; et
- une portion finale cylindrique de diamètre augmenté (autrement dit de diamètre supérieur à celui de la portion initiale) qui se termine par l'extrémité libre portant l'organe de connexion 34 connectée sur l'âme centrale 23.

Un tel dispositif élémentaire 1 est employé dans une installation de traitement micro-onde d'une charge, et notamment dans une installation de production d'un plasma comprenant :
- l'enceinte 4 dans le volume de laquelle la charge est confinée, cette enceinte 4 étant délimitée par une cloison 40 (comme visible sur les figures 5 et 8) ;
- au moins un générateur d'énergie micro-onde (non illustré), notamment du type générateur à état solide ;
- au moins un câble ou guide coaxial 5 (visible sur la figure 9) raccordé d'une part au générateur et d'autre part au connecteur à structure coaxiale 3 d'un dispositif élémentaire 1 ; et
- au moins un dispositif élémentaire 1 débouchant à l'intérieur de l'enceinte 4, à travers la cloison, comme visible sur les figures 5 et 8.

Il est à noter que le blindage 24 de l'applicateur coaxial 2 :
- soit est constitué d'une pièce rapportée sur l'enceinte 4 et traversant de manière étanche sa cloison 40 ;
- soit vient de matière au moins partiellement avec la cloison 40, autrement dit ce blindage 24 est formé partiellement ou totalement par la cloison 40 elle-même.

## Revendications

1. Dispositif élémentaire (1) d'application d'une énergie micro-onde, comprenant un applicateur coaxial (2) de puissance micro-onde présentant, d'une part, une extrémité distale (21) munie d'un connecteur à structure coaxiale (3) prévu pour le couplage avec un câble ou guide coaxial (5) raccordé à un générateur d'énergie micro-onde et, d'autre part, une extrémité proximale (22) opposée prévue pour déboucher à l'intérieur d'une enceinte (4), ledit applicateur coaxial (2) comprenant :
- une âme centrale (23) conductrice s'étendant selon un axe principal (AP),
- un blindage (24) externe conducteur présentant une paroi périphérique (240) entourant ladite âme centrale (23) et une paroi de fond (241) prévue sur ladite extrémité distale (21) et s'étendant transversalement par rapport audit axe principal (AP),
- un milieu de propagation (25) de l'énergie micro-onde situé entre l'âme centrale (23) et le blindage (24), et
- un corps isolant (26) en matériau diélectrique, transparent à l'énergie micro-onde et disposé sur ladite extrémité proximale (22) ;
où le connecteur à structure coaxiale (3) est pourvu d'un conducteur externe (31) connecté audit blindage (24) et entourant un conducteur interne (32) connecté à ladite âme centrale (23) ;
ledit dispositif élémentaire (1) étant **caractérisé en ce que** le connecteur à structure coaxiale (3) est disposé sur la paroi de fond (241) du blindage (24) en ayant son conducteur externe (31) fixé sur ladite paroi de fond (241) et son conducteur interne (32) raccordé à un élément de connexion (33) longiligne qui traverse ladite paroi de fond (241) et qui s'étend, à partir de ladite paroi de fond (241), substantiellement parallèlement à l'axe principal (AP) avec un écartement prédéfini vis-à-vis de ladite âme centrale (23) jusqu'à une extrémité libre connectée sur ladite âme centrale (23) à une distance (D) prédéfinie de ladite paroi de fond (241).

2. Dispositif élémentaire (1) selon la revendication 1, dans lequel l'âme centrale (23) supporte un organe de connexion (34) qui est au contact avec l'extrémité libre de l'élément de connexion (33) à la distance (D) prédéfinie de ladite paroi de fond (241).

3. Dispositif élémentaire (1) selon la revendication 2, dans lequel l'organe de connexion (34) est fixé sur l'extrémité libre de l'élément de connexion (33).

4. Dispositif élémentaire (1) selon la revendication 3, dans lequel l'organe de connexion (34) est fixé sur l'extrémité libre de l'élément de connexion (33) par vissage au moyen d'une vis (35).

5. Dispositif élémentaire (1) selon la revendication 3, dans lequel l'organe de connexion (34) est fixé sur l'extrémité libre de l'élément de connexion (33) par soudage.

6. Dispositif élémentaire (1) selon la revendication 3, dans lequel l'organe de connexion (34) est fixé sur l'extrémité libre de l'élément de connexion (33) par sertissage.

7. Dispositif élémentaire (1) selon l'une quelconque des revendications 2 à 6, dans lequel l'organe de connexion (34) est soudé sur l'âme centrale (23).

8. Dispositif élémentaire (1) selon l'une quelconque des revendications 1 à 3, dans lequel l'élément de connexion (33) se présente sous la forme d'une tige cylindrique de diamètre constant.

9. Dispositif élémentaire (1) selon l'une quelconque des revendications 1 à 7, dans lequel l'élément de connexion (33) présente successivement :
- une portion initiale cylindrique de diamètre réduit connectée au conducteur interne (32) du connecteur à structure coaxiale (3) ;
- une portion intermédiaire tronconique ;
- une portion finale cylindrique de diamètre augmenté qui se termine par l'extrémité libre connectée sur ladite âme centrale (23).

10. Dispositif élémentaire (1) selon l'une quelconque des revendications précédentes, dans lequel ledit dispositif élémentaire (1) constitue un dispositif élémentaire (1) de production d'un plasma à l'intérieur de l'enceinte (4).

11. Installation de traitement micro-onde d'une charge, comprenant :
- une enceinte (4) dans le volume de laquelle la charge est confinée ;
- au moins un générateur d'énergie micro-onde ;
- au moins un dispositif élémentaire (1) conforme à l'une quelconque des revendications précédentes, dont le connecteur à structure coaxiale (3) est connecté à un câble ou guide coaxial (5) raccordé audit générateur d'énergie micro-onde et dont l'extrémité proximale (22) de l'applicateur coaxial (2) débouche à l'intérieur de ladite enceinte (4).

12. Installation de traitement micro-onde selon la revendication 11, dans laquelle le générateur d'énergie micro-onde est un générateur à état solide.

## Patentansprüche

1. Elementare Vorrichtung (1) zur Anwendung einer Mikrowellenenergie, einen koaxialen Applikator (2) für Mikrowellenleistung umfassend, der einerseits ein distales Ende (21) aufweist, das mit einem Stecker mit Koaxialstruktur (3) ausgerüstet ist, der vorgesehen ist zur Kopplung mit einem koaxialen Kabel oder Leitung (5), die an einen Mikrowellenenergiegenerator angeschlossenen ist, und andererseits ein gegenüberliegendes proximales Ende (22), das vorgesehen ist, um innerhalb eines Gehäuses (4) auszumünden, wobei der koaxiale Applikator (2) umfasst:
- einen leitfähigen Mittelkern (23), der sich entlang einer Hauptachse (AP) erstreckt,
- eine leitfähige externe Abschirmung (24), die eine Umfangswand (240) aufweist, die den Mittelkern (23) umgibt, und eine Bodenwand (241), die am distalen Ende (21) vorgesehen ist, und sich quer zur Hauptachse (AP) erstreckt,
- ein Mikrowellenenergie-Ausbreitungsmedium (25), das sich zwischen dem Mittelkern (23) und der Abschirmung (24) befindet, und
- einen Isolierkörper (26) aus dielektrischem Material, der für Mikrowellenenergie transparent ist und am proximalen Ende (22) angeordnet;
wobei der Stecker mit Koaxialstruktur (3) mit einem externen Leiter (31) versehen ist, der mit der Abschirmung (24) verbunden ist und einen internen Leiter (32) umgibt, der mit dem Mittelkern (23) verbunden ist;
wobei die elementare Vorrichtung (1) **dadurch gekennzeichnet ist, dass** der Stecker mit Koaxialstruktur (3) an der Bodenwand (241) der Abschirmung (24) angeordnet ist, indem sein externer Leiter (31) an der Bodenwand (241) befestigt ist und sein interner Leiter (32) an ein längliches Verbindungselement (33) angeschlossen ist, das durch die Bodenwand (241) verläuft und sich von der Bodenwand (241) aus erstreckt, im Wesentlichen parallel zur Hauptachse (AP) mit einem vordefinierten Zwischenraum gegenüber dem Mittelkern (23) bis zu einem freien Ende, das mit dem Mittelkern (23) in einem vordefinierten Abstand (D) von der Bodenwand (241) verbunden ist.

2. Elementare Vorrichtung (1) nach Anspruch 1, wobei der Mittelkern (23) ein Verbindungsglied (34) trägt, das mit dem freien Ende des Verbindungselements (33) im vordefinierten Abstand (D) von der Bodenwand (241) in Kontakt steht.

3. Elementare Vorrichtung (1) nach Anspruch 2, wobei das Verbindungsglied (34) am freien Ende des Verbindungselements (33) befestigt ist.

4. Elementare Vorrichtung (1) nach Anspruch 3, wobei das Verbindungsglied (34) durch Verschrauben mit einer Schraube (35) am freien Ende des Verbindungselements (33) befestigt ist.

5. Elementare Vorrichtung (1) nach Anspruch 3, wobei das Verbindungsglied (34) durch Schweißen am freien Ende des Verbindungselements (33) befestigt ist.

6. Elementare Vorrichtung (1) nach Anspruch 3, wobei das Verbindungsglied (34) durch Crimpen am freien Ende des Verbindungselements (33) befestigt ist.

7. Elementare Vorrichtung (1) nach einem der Ansprüche 2 bis 6, wobei das Verbindungsglied (34) auf den Mittelkern (23) geschweißt ist.

8. Elementare Vorrichtung (1) nach einem der Ansprüche 1 bis 3, wobei das Verbindungselement (33) als zylindrischer Stab mit konstantem Durchmesser vorliegt.

9. Elementare Vorrichtung (1) nach einem der Ansprüche 1 bis 7, wobei das Verbindungselement (33) nacheinander aufweist:
- einen zylindrischen Anfangsabschnitt mit reduziertem Durchmesser, der mit dem internen Leiter (32) des Steckers mit Koaxialstruktur (3) verbunden ist;
- einen kegelförmigen Zwischenabschnitt;
- einen zylindrischen Endabschnitt mit vergrößertem Durchmesser, der mit dem freien Ende endet, das mit dem Mittelkern (23) verbunden ist.

10. Elementare Vorrichtung (1) nach einem der vorhergehenden Ansprüche, wobei die elementare Vorrichtung (1) eine elementare Vorrichtung (1) zur Erzeugung eines Plasmas innerhalb des Gehäuses (4) darstellt.

11. Anlage zur Mikrowellenbehandlung einer Ladung, umfassend:
- ein Gehäuse (4), in dessen Volumen die Ladung eingegrenzt ist;
- mindestens einen Mikrowellenenergiegenerator;
- mindestens eine elementare Vorrichtung (1) nach einem der vorhergehenden Ansprüche, deren Stecker mit Koaxialstruktur (3) mit einem koaxialen Kabel oder Leitung (5) verbunden ist, die an den Mikrowellenenergiegenerator angeschlossenen ist, und deren proximales Ende (22) des koaxialen Applikators (2) innerhalb des Gehäuses (4) ausmündet.

12. Anlage zur Mikrowellenbehandlung nach Anspruch 11, wobei der Mikrowellenenergiegenerator ein Festkörpergenerator ist.

## Claims

1. An elementary device (1) for applying a microwave energy, comprising a microwave power coaxial applicator (2) having, on the one hand, a distal end (21) provided with a coaxial structure connector (3) provided for the coupling with a coaxial cable or guide (5) connected to a microwave energy generator and, on the other hand, an opposite proximal end (22) provided to emerge inside a chamber (4), said coaxial applicator (2) comprising:
- a conductive central core (23) extending along a main axis (AP),
- an outer conductive shield (24) having a peripheral wall (240) surrounding said central core (23) and a bottom wall (241) provided on said distal end (21) and extending transversely relative to said main axis (AP),
- a medium (25) for propagating the microwave energy located between the central core (23) and the shield (24), and
- an insulating body (26) made of dielectric material transparent to the microwave energy and disposed on said proximal end (22);
wherein the coaxial structure connector (3) is provided with an outer conductor (31) connected to said shield (24) and surrounding an inner conductor (32) connected to said central core (23);
said elementary device (1) being **characterized in that** the coaxial structure connector (3) is arranged on the bottom wall (241) of the shield (24) by having its outer conductor (31) fastened onto said bottom wall (241) and its inner conductor (32) connected to an elongate connecting element (33) passing through said bottom wall (241) and extending from said bottom wall (241) substantially parallel to the main axis (AP) with a predefined space relative to said central core (23) up to a free end connected to said central core (23) at a predefined distance (D) from said bottom wall (241).

2. The elementary device (1) according to claim 1, wherein the central core (23) supports a connecting member (34) which is in contact with the free end of the connecting element (33) at the predefined distance (D) from said bottom wall (241).

3. The elementary device (1) according to claim 2, wherein the connecting member (34) is fastened onto the free end of the connecting element (33).

4. The elementary device (1) according to claim 3, wherein the connecting member (34) is fastened onto the free end of the connecting element (33) by screwing by means of a screw (35).

5. The elementary device (1) according to claim 3, wherein the connecting member (34) is fastened onto the free end of the connecting element (33) by welding.

6. The elementary device (1) according to claim 3, wherein the connecting member (34) is fastened onto the free end of the connecting element (33) by crimping.

7. The elementary device (1) according to any one of the claims 2 to 6, wherein the connecting member (34) is welded onto the central core (23).

8. The elementary device (1) according to any one of the claims 1 to 3, wherein the connecting element (33) has the shape of a cylindrical stem of constant diameter.

9. The elementary device (1) according to any one of the claims 1 to 7, wherein the connecting element (33) has successively:
- an initial cylindrical portion of reduced diameter connected to the inner conductor (32) of the coaxial structure connector (3);
- an intermediate truncated-cone-shaped portion;
- a final cylindrical portion of increased diameter which ends with the free end connected to said central core (23).

10. The elementary device (1) according to any one of the preceding claims, wherein said elementary device (1) constitutes an elementary device (1) for producing a plasma inside the chamber (4).

11. A microwave treatment installation of a load, comprising:
- a chamber (4) in the volume of which the load is confined;
- at least one microwave energy generator;
- at least one elementary device (1) in accordance with any one of the preceding claims, whose coaxial structure connector (3) is connected to a coaxial cable or guide (5) connected to said microwave energy generator and whose proximal end (22) of the coaxial applicator (2) emerges inside said chamber (4).

12. The microwave treatment installation according to claim 11, wherein the microwave energy generator is a solid-state generator
